Europäisches Patentamt

European Patent Office

Office européen des brevets

(11) Numéro de publication: **0 233 104**
**A1**

## (12) DEMANDE DE BREVET EUROPEEN

(21) Numéro de dépôt: **87400096.1**

(22) Date de dépôt: **16.01.87**

(51) Int. Cl.⁴: **H 04 N 3/15**
**H 01 L 27/14**
**// A61B6/00**

(30) Priorité: **20.01.86 FR 8600716**

(43) Date de publication de la demande:
**19.08.87 Bulletin 87/34**

(84) Etats contractants désignés: **DE GB NL**

(71) Demandeur: **THOMSON-CSF**
**173, Boulevard Haussmann**
**F-75379 Paris Cedex 08 (FR)**

(72) Inventeur: **Arques, Marc**
**THOMSON-CSF SCPI 19, avenue de Messine**
**F-75008 Paris (FR)**

**Berger, Jean-Luc**
**THOMSON-CSF SCPI 19, avenue de Messine**
**F-75008 Paris (FR)**

(74) Mandataire: **Turlèque, Clotilde et al**
**THOMSON-CSF SCPI 19, avenue de Messine**
**F-75008 Paris (FR)**

(54) **Matrice d'élements photosensibles et son procédé de fabrication, procédé de lecture associé, et application de cette matrice à la prise de vue d'images.**

(57) L'invention a pour objet une matrice d'éléments photosensibles, dans laquelle chaque élément photosensible se réduit à l'association d'une diode (D) et d'une capacité (C). Son procédé de fabrication est donc facile notamment à partir de silicium amorphe. Son procédé de lecture met en oeuvre une lecture multiplexée des colonnes : les n colonnes sont réparties en groupe de $\frac{n}{M}$ colonnes successives commandés simultanément par M registres à décalage horizontaux ($RH_1$,...$RH_M$), chacun associé à un intégrateur de lecture ($A_1$,...$A_M$). Pour assurer une lecture correcte des signaux utiles, quel que soit leur niveau, une remise à niveau de la tension ($V_P - V_A$) aux bornes des diodes des éléments photosensibles est effectuée afin que la tension de départ ($V_{A0}$) au début de chaque impulsion de lecture appliqué à une ligne soit telle que seule, et même avec un signal d'éclairement utile maximum, cette impulsion ne puisse polariser la diode en direct, et que avec une impulsion d'adressage de colonne, la diode soit polarisée en direct même en l'absence de signal utile.

Application, notamment, à la prise de vue d'images radiologiques.

FIG.1

# Description

Matrice d'éléments photosensibles et son procédé de fabrication, procédé de lecture associé, et application de cette matrice à la prise de vue d'images.

L'invention se rapporte aux techniques d'imagerie et plus particulièrement à la prise de vue, notamment pour images radiologiques, au moyen de matrices d'éléments photosensibles.

La réalisation d'une matrice d'éléments photosensibles de grande dimension se heurte à de nombreuses difficultés tant au niveau de la structure des éléments photosensibles, qui doit être aussi simple que possible pour des raisons de rendement de fabrication, qu'au niveau de l'utilisation de cette matrice, la lecture des éléments photosensibles devant, pour être efficace, être rapide et à faible bruit.

Un premier objet de la présente invention est une matrice d'éléments photosensibles interconnectés dans laquelle chaque élément se limite à l'association d'une photodiode et d'une capacité. L'avantage d'un tel élément photosensible est d'être dépourvu d'élément de commutation ; il présente donc un rendement de fabrication potentiel élevé. Par contre sa lecture nécessite l'emploi d'un amplificateur opérationnel intégrateur, et requiert un temps relativement long pour être efficace et à faible bruit.

Selon l'invention une matrice d'éléments photosensibles comportant un ensemble de p lignes de n éléments photosensibles, chaque élément ayant une première et une seconde borne, est caractérisée en ce que chaque élément comporte en série une photodiode et une capacité, les premières bornes des éléments d'une même ligne étant interconnectées et reliées via un interrupteur commandé par une sortie d'un registre à décalage vertical à un potentiel d'adressage ligne, et les secondes bornes des éléments d'une même colonne étant interconnectées et reliées à un interrupteur, commandé par une sortie de l'un de M registres à décalage à $\frac{n}{M}$ étages, en série avec l'entrée "-" de l'un des M amplificateurs opérationnels montés en intégrateur, les entrées "+" des intégrateurs étant reliées à l'entrée d'adressage colonne, chaque conducteur de colonne étant également relié, via un interrupteur commandé par des impulsions de remise à niveau à l'entrée d'adressage colonne, les entrées de commande de décalage des registres horizontaux étant reliées à une même entrée de commande, chaque intégrateur comportant des moyens de remise à zéro de la capacité d'intégration.

Un second objet de l'invention est le procédé de fabrication de cette matrice.

Selon l'invention un procédé de fabrication d'une matrice d'éléments photosensibles, est caractérisé en ce qu'il consiste :
- à déposer sur un substrat transparent une première couche de matériau conducteur semi-transparent et à la graver pour obtenir des conducteurs parallèles,
- à déposer sur cet ensemble des couches successives de matériau semi-conducteur, respectivement dopée, non dopée et dopée nécessaires pour former des diodes photosensibles, puis à les graver pour isoler des diodes,
- à recouvrir cet ensemble d'une couche de matériau diélectrique pour réaliser des capacités, en série avec les diodes,
- puis, à déposer une couche de matériau conducteur semi-transparent sur la couche diélectrique, et à la graver pour réaliser des conducteurs de colonne orthogonaux aux conducteurs de ligne et reliant les capacités d'une même ligne.

Un autre objet de l'invention est le procédé de lecture associé à cette matrice d'éléments photosensibles. Il effectue un multiplexage des colonnes de la matrice, de façon que les amplificateurs intégrateurs fonctionnent dans des conditions satisfaisantes, sans en multiplier trop le nombre.

Selon l'invention, le procédé de lecture associé à la matrice telle que décrite ci-dessus est caractérisé :

- en ce que pour la lecture, les registres à décalage horizontaux sont commandés en parallèle, la lecture des colonnes étant multiplexée : les éléments photosensibles d'une ligne sont adressés par une tension d'adressage appliquée simultanément aux colonnes de rangs k, $k + \frac{n}{M}$, $k + 2\frac{n}{M}$..., au moyen des sorties de rang k des registres à décalage horizontaux, k étant un nombre entier compris entre 1 et $\frac{n}{M}$, une séquence d'adressage de colonnes comportant une séquence de $\frac{n}{M}$ impulsions,
- et en ce qu'une phase de remise à niveau des tensions aux bornes des diodes est prévue, par application d'un fond de charge aux éléments photosensibles, entre les séquences de lecture, pour ramener la tension aux bornes des diodes d'une ligne à lire à une valeur initiale $V_{A0}$ telle que les impulsions de lecture ligne seules ne puissent les polariser en direct même après un éclairement maximum, et que les impulsions de commande ligne associées aux impulsions d'adressage colonne les polarise fortement en direct, même en l'absence de rayonnement utile.

Le dernier objet de l'invention est l'application de cette matrice à la prise de vue d'images, notamment radiologiques.

L'invention sera mieux comprise et d'autres caractéristiques apparaîtront à l'aide de la description qui suit en référence aux figures annexées.

La figure 1 représente une matrice d'éléments photosensibles selon l'invention, et les moyens de lecture associés ;

La figure 2 est un schéma de détail d'un élément photosensible et des moyens de lecture associés ;

Les figures 3a à 3h représentent des signaux explicatifs du fonctionnement de la matrice selon l'invention avec une première variante de procédé de lecture ;

La figure 4 est un schéma de détails de l'un des signaux décrits en référence à la figure 3 ;

Les figures 5a et 5b représentent des vues en coupe, respectivement selon une colonne et selon une ligne, d'une matrice obtenue selon une première variante de procédé de fabrication ;

Les figures 6a et 6b représentent des vues en coupe, respectivement selon une colonne et selon une ligne, d'une matrice obtenue selon une seconde variante de procédé de fabrication.

Les figures 7a, 7b...7h représentent des signaux explicatifs du fonctionnement de la matrice avec une seconde variante du procédé de lecture ;

Les figures 8a, 8b...8h représentent des signaux explicatifs du fonctionnement de la matrice avec une troisième variante du procédé de lecture.

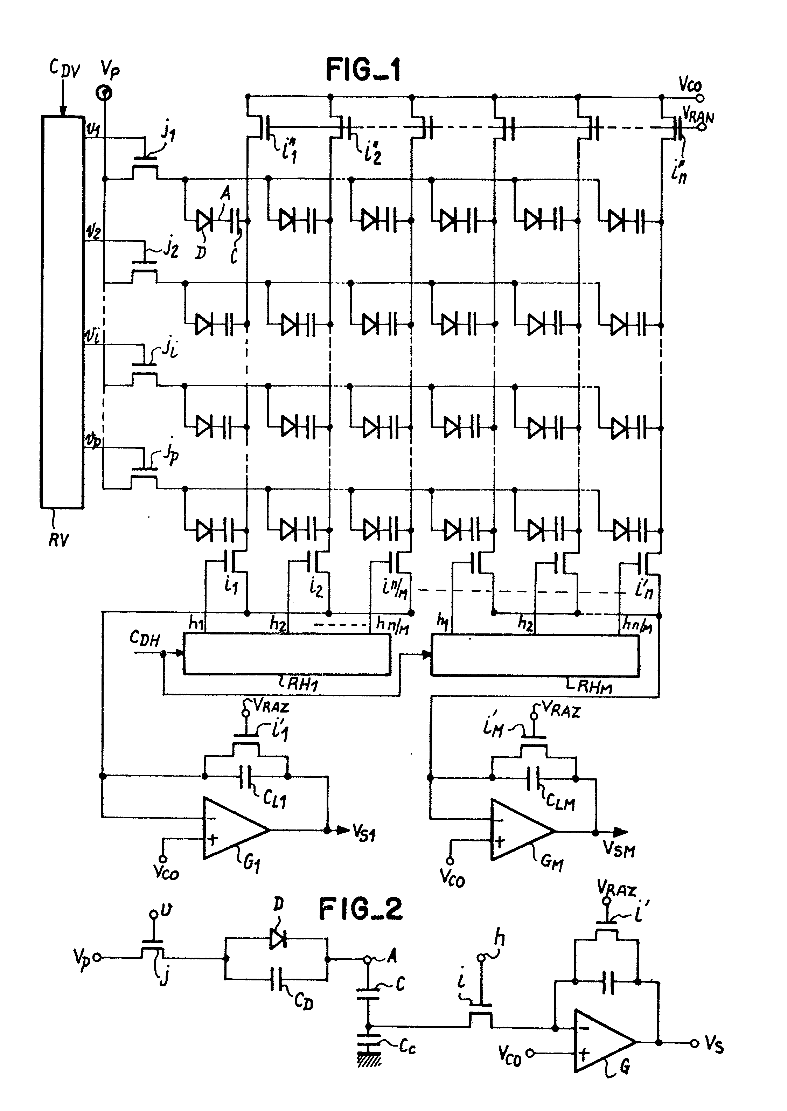

Sur la figure 1 qui représente une vue d'ensemble de la matrice photosensible, un nombre n.p éléments photosensibles, chacun constitué d'une photodiode D en série avec une capacité C, sont arrangés suivant les lignes et les colonnes d'une matrice de p lignes et n colonnes, les diodes d'une même ligne sont reliées entre elles par une connexion de ligne, tandis que les capacités C d'une même colonne sont reliées entre elles par une connexion de colonne. Les connexions de lignes sont reliées à une tension d'adressage $V_P$ par l'intermédiaire de transistors MOS interrupteurs, $j_1$, $j_2$...$j_p$ commandés par les sorties $v_1$, $v_2$...$v_p$ d'un registre à décalage dit registre à décalage vertical, RV. Ce registre est commandé par un signal de commande $C_{DV}$ de décalage vertical. Ainsi, lorsqu'une ligne est sélectionnée pour être lue, toutes les diodes de cette ligne sont portées au niveau haut $V_{P1}$ du potentiel d'adressage $V_P$. De la même manière, les capacités d'une même colonne sont reliées aux entrées d'amplificateurs opérationnels montés en intégrateurs, par l'intermédiaire de transistors MOS interrupteurs $i_1$, $i_2$..., $i_n$ commandés par les sorties des étages de registres à décalage horizontaux.

Selon l'invention, le procédé de lecture réalise un multiplexage des colonnes de la matrice, pour ne pas utiliser un amplificateur intégrateur par colonne : plusieurs colonnes successives sont reliées à l'entrée d'un même amplificateur opérationnel intégrateur. Les moyens de lecture comportent donc M amplificateurs, M étant un diviseur de n, et M registres à décalage horizontaux, chaque amplificateur et le registre à décalage horizontal associé étant utilisés pour la lecture de $\frac{n}{M}$ colonnes. Ainsi, les $\frac{n}{M}$ premières colonnes sont reliées aux sorties d'un registre à décalage horizontal $RH_1$, à $\frac{n}{M}$ étages, les connexions de colonnes correspondantes étant reliées à l'entrée "-" d'un amplificateur opérationnel $G_1$ monté en intégrateur : sa sortie est reliée à son entrée "-" par l'intermédiaire d'un condensateur de lecture $C_{L1}$. L'entrée "+" de cet intégrateur est reliée à un point de potentiel de référence colonne $V_{CO}$.

Cette structure est répétée pour chaque paquet de $\frac{n}{M}$ colonnes, le dernier amplificateur $G_M$ reliant les $\frac{n}{M}$ dernières colonnes. Les condensateurs d'intégration $C_L$ sont remis à zéro par des interrupteurs $i'_1$...$i'_M$ commandés par des impulsions de remise à zéro, $V_{RAZ}$. Enfin, toutes les colonnes peuvent être ensembles initialisées au potentiel de référence colonne $V_{CO}$ par une ligne de transistors MOS, $i''_1$, $i''_2$...$i''_n$ commandés par des impulsions de remise à niveau $V_{RAN}$. Les registres à décalage horizontaux sont commandés simultanément, par un signal de commande de décalage horizontal $C_{DH}$ appliqué à leurs entrées de commande, leurs sorties de même rang étant synchrones et délivrant les signaux, $h_1$, $h_2$,..., $h_{n/M}$. Les tensions de sortie des amplificateurs opérationnels intégrateurs sont $V_{S1}$...$V_{SM}$.

La figure 2 représente en détails le schéma équivalent d'un élément photosensible à photodiode D et capacité C, avec les différentes commandes d'adressage et l'amplificateur de sortie correspondant. Lorsque cet élément photosensible est sélectionné par le registre vertical $R_V$ de la figure 1, l'interrupteur j correspondant est fermé par la commande v et le potentiel $V_P$ est appliqué sur la diode D. La capacité $C_D$ de la diode a été représentée en parallèle sur cette diode D. Le point commun à la diode D et la capacité C a été désigné par A, l'autre extrémité de la capacité C étant reliée à l'entrée "-" de l'amplificateur opérationnel intégrateur G par l'intermédiaire du transistor MOS interrupteur i commandé par la sortie h d'un registre à décalage horizontal de sélection de la colonne. Entre cette même borne de C et la masse a été représentée la capacité de la connexion de colonnes $C_c$.

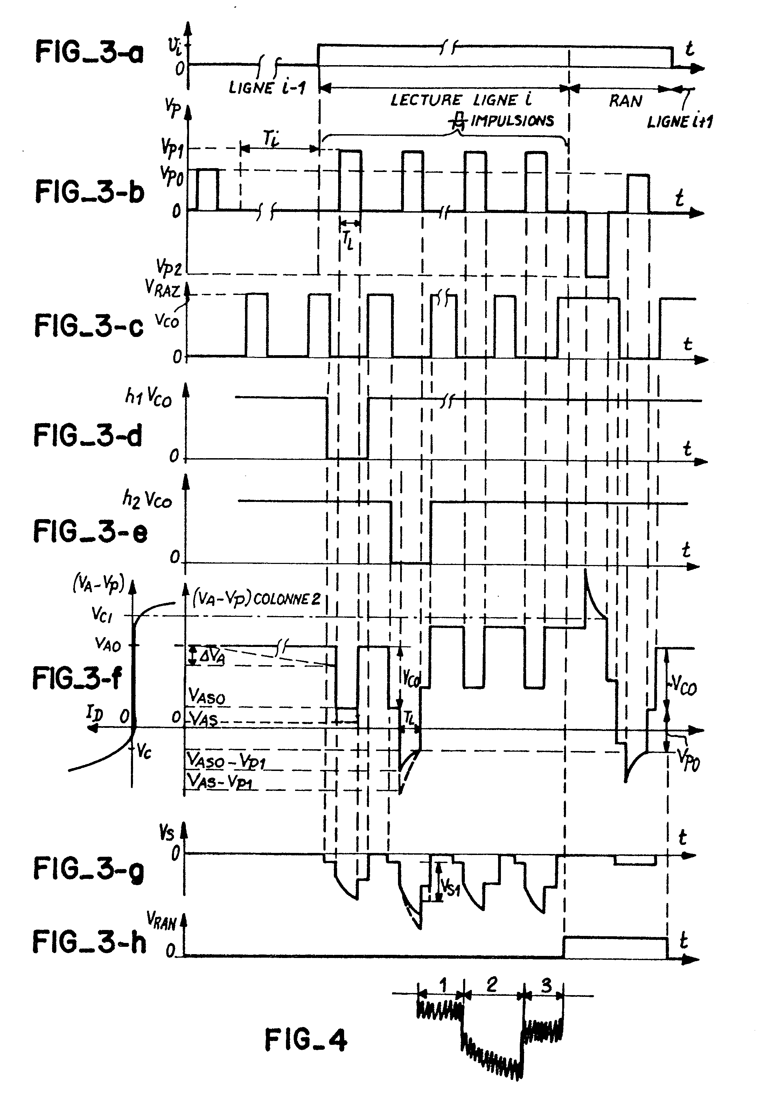

Les diagrammes des figures 3a à 3h représentent les différents signaux appliqués ou obtenus lors de la lecture d'un élément photosensible.

Si l'on considère les opérations de lecture de la $i^{ème}$ ligne, toutes les diodes de cette ligne ont été polarisées en inverse par la précédente lecture de cette même ligne, une durée $T_i$ auparavant, cette durée étant au minimum la durée nécessaire pour la lecture de toutes les autres lignes. Les points A communs entre diode D et capacité C des éléments photosensibles de cette ligne sont alors polarisés positivement, et laissés flottants pendant toute la durée $T_i$, cette durée étant également mise à profit pour l'intégration de l'information lumineuse à enregistrer par cette ligne. Le photocourant propre à chaque diode abaisse plus ou moins le potentiel de chaque point A par la décharge de chaque couple capacitif formé par la capacité C et la capacité de la diode $C_D$, comme le montre la figure 3f représentant la tension aux bornes d'une diode, où les traits pleins et pointillés représentent respectivement le cas où il n'y a pas de signal lumineux utile et le cas où il y a un signal lumineux utile. $C_D$ est supposée petite devant C, c'est-à-dire $C_D$ est inférieure ou égale à $\frac{C}{10}$.

Les opérations de lecture de la ligne se décomposent en deux séquences successives :
- tout d'abord la lecture séquentielle des informations stockées sur les points A des différents groupes de $\frac{n}{M}$ éléments photosensibles, les M groupes de colonnes étant lus simultanément grâce aux M registres à décalages horizontaux et aux M amplificateurs intégrateurs ;
- dans une seconde phase, la restauration simultanée du potentiel initial $V_{A0}$ des points A de toute la ligne, par une remise à niveau, soit au moyen d'une impulsion de polarisation négative appliquée à cette ligne suivie d'une lecture à blanc, soit au moyen d'un éclairement uniforme calibré appliqué sélectivement à la ligne de photodétecteurs, soit au moyen d'un flash lumineux intense suivi d'une lecture à blanc.

Ces deux opérations s'effectuent grâce à l'aiguillage de la tension d'adressage $V_P$ sur la ième ligne par le registre à décalage vertical $R_V$ qui commande la fermeture de l'interrupteur $j_i$ correspondant à cette ligne : la tension appliquée à la ligne, $V_p$ est nulle pendant toute la durée $T_i$ et égale au niveau haut de $V_P$, $V_{P1}$ pendant la durée des impulsions de lecture $T_L$ comme le montre la figure 3b. La première séquence est une suite de $\frac{n}{M}$ impulsions de lecture, synchrones des impulsions de remise à zéro $V_{RAZ}$ court circuitant les condensateurs de lecture $C_L$ et des impulsions d'adressage $V_{CO}.h$ appliquées aux entrées positives des M amplificateurs, comme représenté sur les figures 3c où a été représenté $V_{CO}$ et $V_{RAZ}$, 3d et 3e où ont été représentés les produits logiques $V_{CO}.h_1$ et $V_{CO}.h_2$, correspondant à l'adressage des deux premières colonnes de chaque groupe. Ces impulsions d'adressage colonne, $V_{CO}.h$ résultent de la combinaison logique d'impulsions h commandant les interrupteurs i et d'impulsions appliquées au point de potentiel de référence des colonnes $V_{CO}$. Les impulsions h encadrent les impulsions $V_{CO}$ de façon que, à la fin d'une durée de lecture $T_L$, la tension de colonne soit bien ramenée au niveau haut de $V_{CO}$ avant la remise à niveau. Les impulsions d'adressage colonne et de remise à zéro débordent de chaque côté des impulsions de lecture $V_P$ : les impulsions $V_P$ passent au niveau haut $V_{P1}$ après que les impulsions $V_{CO}$ soient passées au niveau bas. Les impulsions de lecture ne sont donc transmises que sur les colonnes sélectionnées par les registres à décalage horizontaux, les autres colonnes restent chargées, au niveau haut de $V_{CO}$.

La figure 3f décrit l'évolution du potentiel $V_A$-$V_P$ aux bornes des diodes des colonnes 2, $\frac{n}{M}+2$, $2\frac{n}{M}+2$... Pendant l'adressage des colonnes précédentes 1, $\frac{n}{M}+1$, $2\frac{n}{M}+1$..., les autres colonnes demeurant au niveau haut, l'impulsion sur $V_P$ doit être d'amplitude $V_{P1}$ insuffisante pour polariser leurs diodes en direct, en l'absence de rayonnement utile, $V_{AS0} \geq 0$, et également en présence de rayonnement $V_{AS} \geq 0$. C'est ce qui apparaît sur la figure 3f où a été représentée, en plus de la tension $V_A$-$V_P$ en fonction du temps, la caractéristique de la diode : $I_D$ courant dans la diode en fonction de $V_A$-$V_P$ tension à ses bornes. Comme indiqué ci-dessus, le tracé en trait plein représente le potentiel en l'absence d'éclairement, le tracé en pointillés représente le potentiel d'une diode ayant intégrée une information lumineuse $Q_S$ pendant la période d'intégration $T_i$. $\Delta V_A$ représente l'amplitude du signal stocké sur la capacité C, les charges $Q_S$ étant égales à $C.\Delta V_A$.

L'amplitude de la variation de la tension aux bornes de la diode lors du passage de $V_P$ au niveau haut $V_{P1}$ est voisine de la variation d'amplitude de $V_P$. La lecture des M colonnes suivantes, 2, $\frac{n}{M}+2$... s'effectue par la coïncidence d'une impulsion $V_P$ avec la tension d'adressage correspondante représenté par le produit logique $V_{CO}.h_2$ sur ces colonnes. Dans ce cas l'amplitude de la variation de la tension aux bornes de la diode doit être suffisante pour polariser la diode largement en direct, même en l'absence de signal lumineux utile, au niveau $V_{AS0}$ - $V_{P1}$, et bien entendu en présence de signal $V_{AS}$ - $V_{P1}$. Si cette condition est réalisée, la tension aux bornes de la diode évolue pendant le temps de lecture $T_L$ jusqu'à une valeur $V_C$ indépendante de la tension de polarisation initiale et donc du signal. Cette tension est la tension de coude de la diode D. Dans ce cas la charge signal se trouve intégralement transmise à la capacité $C_L$ de l'amplificateur intégrateur correspondant, quelle que soit son amplitude. Elle se trouve additionnée à une charge $Q_0$ qui est la charge lue en l'absence de signal. L'intégrateur $G_1$, $C_{L1}$ délivre alors en sortie une tension $V_{S1}$ en présence de signal lumineux sur la colonne 2 qui correspond à la charge utile $Q_S$ et à

$$Q_0 : \frac{Q_S + Q_0}{C_L}.$$

. Cette tension est disponible directement après le retour à zéro de la tension $V_P$ et peut alors être prélevée par un échantillonneur avant le retour à zéro par $V_{RAZ}$. Les signaux $V_{CO}$ et $V_{RAZ}$ sont en phase mais peuvent avoir des niveaux différents.

Lors du retour de $h_2.V_{CO}$ au niveau haut, la diode D se trouve plus fortement polarisée en inverse qu'initialement du fait de la lecture de la charge $Q_0 + Q_S$. Le potentiel du point A s'écrit en effet

$$V_A = V_{A0} + \frac{Q_0 + Q_S}{C + C_D}.$$

Pendant la lecture de toutes les autres colonnes, la diode reste polarisée en inverse sans être affectée par les variations de potentiel de $V_P$.

Au terme des $\frac{n}{M}$ impulsions de $V_P$, la séquence de lecture des colonnes est achevée pour la ligne i. La phase de remise à niveau de tous les points flottants A des diodes de cette ligne est alors effectuée. Le but de cette remise à niveau est de restaurer sur les diodes un potentiel $V_{A0}$ tel que les impulsions de $V_P$ ne puisse les polariser en direct lors d'une lecture même pour un éclairement maximum, et en même temps que la somme des amplitudes de $V_P$ et de $V_{CO}$ les polarise fortement en direct même en l'absence de signal. Cette double condition permet de sélectionner la lecture de chaque diode par la coïncidence des impulsions de commande de ligne, par $V_P$, et des impulsions de commande de colonne par $V_{CO}$ selon la description ci-dessus.

Pour obtenir le potentiel $V_{A0}$ nécessaire, il faut tout d'abord décharger le couple de capacités C et $C_D$, que l'opération de lecture précédente a rechargé à une tension supérieure à $V_{A0}$ où la diode ne peut plus être lue convenablement. Plusieurs méthodes sont possibles pour effectuer cette décharge : soit l'utilisation de la conduction en inverse de la diode au delà d'un certain seuil, soit un éclairement intense ou uniforme selon les applications envisagées.

En utilisant le seuil de conduction en inverse de la diode, l'opération de remise à niveau illustrée par les diagrammes de signaux des figures 3a et suivantes consiste à appliquer une impulsion négative d'amplitude $V_{P2}$ par $V_P$ qui polarise la diode au delà de son seuil de conduction en inverse. Celle-ci se décharge jusqu'à la tension de coude inverse $V_{CI}$, indépendante de la tension initiale. Pendant cette opération ainsi que pendant la suivante, toutes les colonnes sont polarisées au niveau haut de $V_{CO}$ par l'intermédiaire des transistors interrupteurs MOS $i''_1...i''_n$ commandés pour la remise à niveau par $V_{RAN}$. Cette opération de polarisation au delà du seuil de conduction en inverse est suivie par une séquence de lecture "à blanc" au terme de laquelle le potentiel final $V_{AO}$ peut être ajusté au moyen d'une impulsion de lecture d'amplitude déterminée $V_{PO}$. Ainsi la charge de polarisation $Q_0$ est ajustée indépendamment de la valeur de tension de coude inverse de la diode, qui peut varier sensiblement d'un élement à l'autre, pour que $V_C + V_{PO} + V_{CO} = V_{AO}$. Au terme de cette séquence le potentiel flottant de toutes les diodes de la $i^{ème}$ ligne est restauré pour commencer une nouvelle intégration de l'information lumineuse.

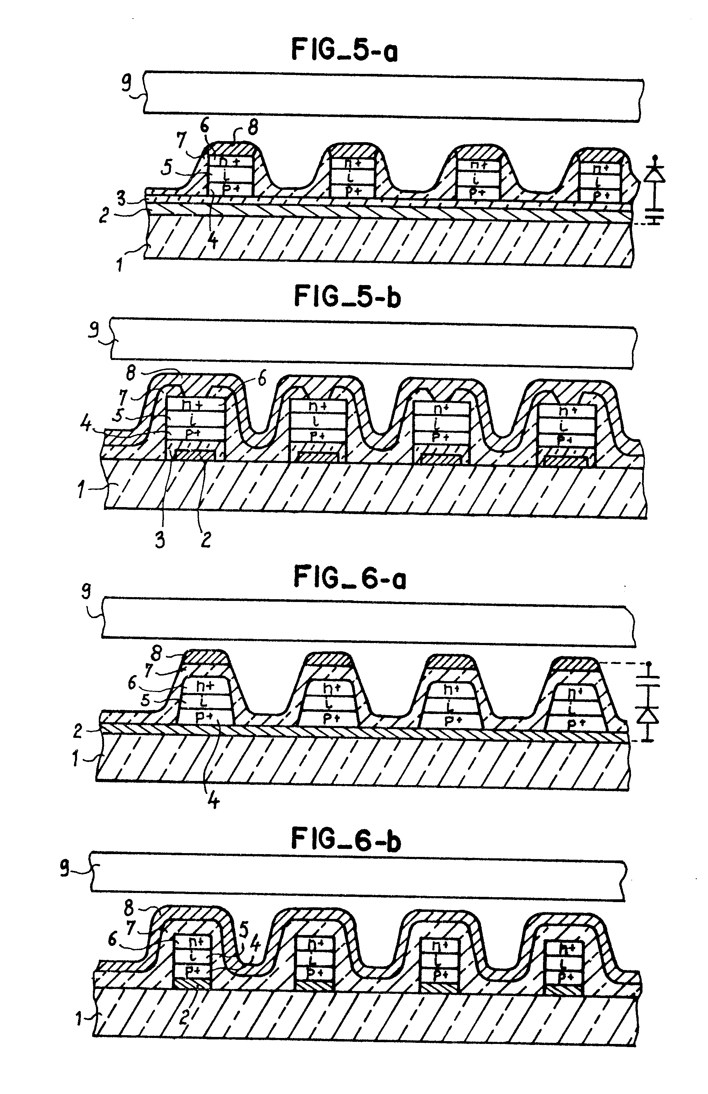

Une matrice d'éléments photosensibles, telle que décrite ci-dessus et représentée schématiquement sur la figure 1 peut être réalisée en suivant le procédé décrit ci-dessous en référence aux figures 5a et 5b pour une première variante, ou aux figures 6a et 6b pour une seconde variante. Les figures 5a et 6a représentent la matrice en coupe suivant une colonne, et les figures 5b et 6b représentent la matrice en coupe suivant une ligne respectivement pour les deux variantes du procédé.

Selon la première variante cette matrice est réalisée à partir de silicium amorphe de la manière suivante : une plaque de verre 1 formant le substrat est recouverte dans une première phase d'une couche de conducteur semi-transparent 2, par exemple du molybdène, du tantale ou de l'ITO (mélange d'oxyde d'indium et d'oxyde d'étain), qui est ensuite gravée pour former les conducteurs de colonnes. Une couche de matériau diélectrique 3 est alors formée, par exemple de l'oxyde de tantale $Ta_2O_5$ de forte constante diélectrique sous une épaisseur de 0.2 µm obtenue par oxydation anodique de la couche précédente si celle-ci est réalisée en tantale, pour former les capacités C. Puis sont déposées sur cette couche les couches de silicium amorphe destinées à former les diodes PIN, D sous une épaisseur de l'ordre de 0.8 µm à 3 µm: par exemple une couche de silicium dopée p+, 4, une couche de silicium intrinsèque i, 5, et une couche de silicium dopée n+, 6. La gravure de ces couches superposées permet alors d'isoler les diodes superposées à la couche diélectrique formant les condensateurs et en contact avec le conducteur inférieur. Une couche de protection isolante 7, formée de nitrure ou d'oxyde de silicium par exemple, est alors déposée ; enfin des contacts sont ouverts dans la couche superficielle d'isolant 7 pour réaliser les conducteurs de ligne. Pour cela une couche de métal semi-transparent 8, ITO par exemple, est déposée ; cette couche est ensuite gravée pour former les conducteurs de ligne.

Pour une application à l'imagerie X l'écran scintillateur 9 peut alors être déposé sur l'ensemble, l'image X étant projetée sur cette face de la matrice. Dans le cas où la remise à niveau est effectuée par éclairement comme il sera expliqué ci-après, les flash optiques de remise à niveau sont projetés du côté de la plaque de verre 1, le scintillateur étant opaque au rayonnement visible.

Selon la deuxième variante, illustrée par les figures 6a et 6b, où les mêmes couches que sur les figures 5a et 5b portent les mêmes références, les diodes sont réalisées avant les capacités, les capacités étant formées à partir de la couche d'isolant 7, ce qui évite l'ouverture de contacts dans cette couche, et évite le dépôt de la couche d'isolant 3. La couche 7 ne peut évidemment plus être réalisée par oxudation du conducteur semi-transparent inférieur (tantale). La succession des couches est alors la suivante : sur la plaque de verre 1 est déposé un matériau conducteur semi-transparent 2 qui est ensuite gravé, puis les couches de silicium 4 dopée p+, 5 intrinsèque, et 6 dopée n+. Après gravure pour isoler les diodes la couche de matériau diélectrique 7 est déposée et constitue les capacité C. La dernière couche 8 de conducteur semi-transparent est alors déposée puis gravée.

On réalise ainsi facilement des matrices de points dans lesquelles chaque zone élémentaire a un côté de l'ordre de 100 µm à 200 µm, et donc des matrices de $2000 \times 2000$ points à $4000 \times 4000$ points dont les dimensions sont de l'ordre de 40 cm $\times$ 40 cm.

La structure ainsi obtenue pour la matrice et le procédé de lecture associé présentent plusieurs avantages dans le cas d'un photosen seur matriciel de grande dimension pour lequel on souhaite obtenir une résolution élevée :

- le bruit de lecture peut être réduit au minimum ;
- la fréquence de fonctionnement des registres à décalage horizontaux peut également être réduite par le facteur M du fait du multiplexage ;
- l'élément photosensible qui est une association capacité et diode a une structure très simple, résistante au rayonnement X, ce qui est un avantage capital pour un senseur destiné à l'imagerie par rayonnement X, employé par exemple avec un scintillateur.

En ce qui concerne la réduction du bruit de lecture, un détail de la tension de sortie est représenté sur la figure 4 où il est possible de distinguer les trois paliers avec les bruits correspondant. Le bruit du palier 1 est celui qui correspond à la charge de la colonne de capacité $C_c$, au niveau bas de $V_{CO}$, proche de 0V.

le bruit du palier 2 est celui du palier 1 auquel s'ajoute le bruit de lecture de la diode. Il est possible de s'affranchir complétement du bruit du palier 1 qui comporte des composantes spatiales (variations d'une colonne à l'autre) et temporelles, en employant pour la lecture de la tension de sortie de l'intégrateur une méthode de double échantillonnage qui consiste à mettre en mémoire le signal du palier 1 sur une capacité et à ne lire que la variation de signal du palier 1 au palier 3.

Le bruit du palier 3 dépend de la tension de bruit d'entrée de l'amplificateur, de sa bande passante B, liée au temps de lecture alloué à chaque colonne.

Le multiplexage, rendu possible par le procédé de coïncidence d'impulsions de tension $V_P$ et $V_{CO}$ respectivement appliquées aux lignes et aux colonnes, décrit ci-dessus permet de réduire la bande passante B et donc de réduire en conséquence la tension de bruit par un facteur $\sqrt{M}$, M étant le taux de multiplexage.

En ce qui concerne la fréquence de fonctionnement des registres à décalage horizontaux, du fait de sa réduction, les registres peuvent être réalisés avec des transistors de mobilité réduite, comme c'est le cas pour une matrice photosensible utilisant un matériau du type silicium amorphe.

Ce matériau est alors utilisé pour l'ensemble de la structure ce qui simplifie considérablement les problèmes de connexion.

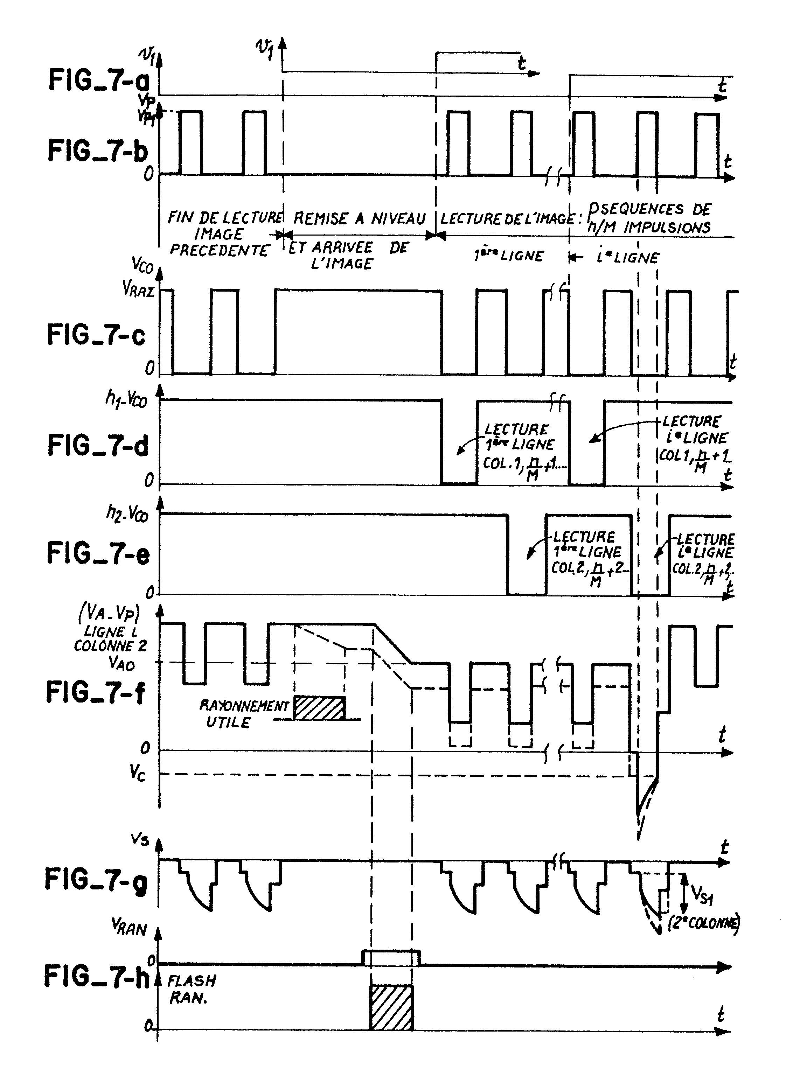

Il a été indiqué ci-dessus que l'opération de remise à niveau indispensable pour que la lecture puisse être répétée, pouvait être effectuée en éclairant uniformément les diodes de façon à les décharger, cet éclairement ayant une intensité et une durée prédéterminées. Les signaux explicatifs de la variante du procédé de lecture mettant en oeuvre une telle remise à niveau sont représentés sur les figures 7 dans le cas d'une application où la remise à niveau est effectuée en une seule fois pour toute la matrice. Les lettres références des figures 7 et suivantes sont identiques à celles des figures 3 et suivantes pour les mêmes signaux. La structure des impulsions $V_P$ est modifiée comme représenté sur la courbe de la figure 7b : l'impulsion négative nécessaire à la décharge pour une remise à niveau électrique est supprimée ; elle est remplacée par l'éclairement calibré représenté sur la figure 7h qui décharge pendant un temps prédéterminé toutes les diodes de la matrice après la lecture de toutes les lignes de l'image précédente. C'est cette décharge qui fixe la tension de départ $V_{A0}$ ; l'impulsion de lecture à blanc d'amplitude $V_{P0}$ est également supprimée. Les impulsions de lecture suivantes réalisent les lectures successives des diodes de la matrice, en coïncidence avec les impulsions $V_{CO}$ commandées par les registres horizontaux. Chaque diode qui vient d'être lue doit se trouver suffisamment polarisée en inverse pour ne plus être affectée par les autres impulsions de la séquence. Pour que les diodes de cette même ligne ne puissent être lues par les coïncidences $V_P$ et $V_{CO}$ destinées à la lecture des lignes suivantes, il importe de choisir le fond de charge de polarisation $Q_0$ supérieur à la charge signal maximal $Q_S$ (max) pour que le potentiel des points A, après lecture, $(V_A-V_P)_{TL}$ soit toujours supérieur à $V_{A0}$. Ce n'est qu'après une nouvelle remise à niveau que la décharge conduit au potentiel des points flottants $V_{A0}$ convenable pour la lecture. Dans cette variante, contrairement aux autres, l'exposition au rayonnement utile peut avoir lieu après la remise à niveau, comme précédemment, mais peut également se faire avant la remise à niveau, ou même en même temps ; ce qui peut être le cas pour une arrivée permanente d'image, dans le cas d'un imageur visible. L'intégration sur chaque ligne a alors lieu pendant la lecture de toutes les autres lignes, mais entre chaque lecture de toute la matrice doit avoir lieu la séquence de remise à niveau.

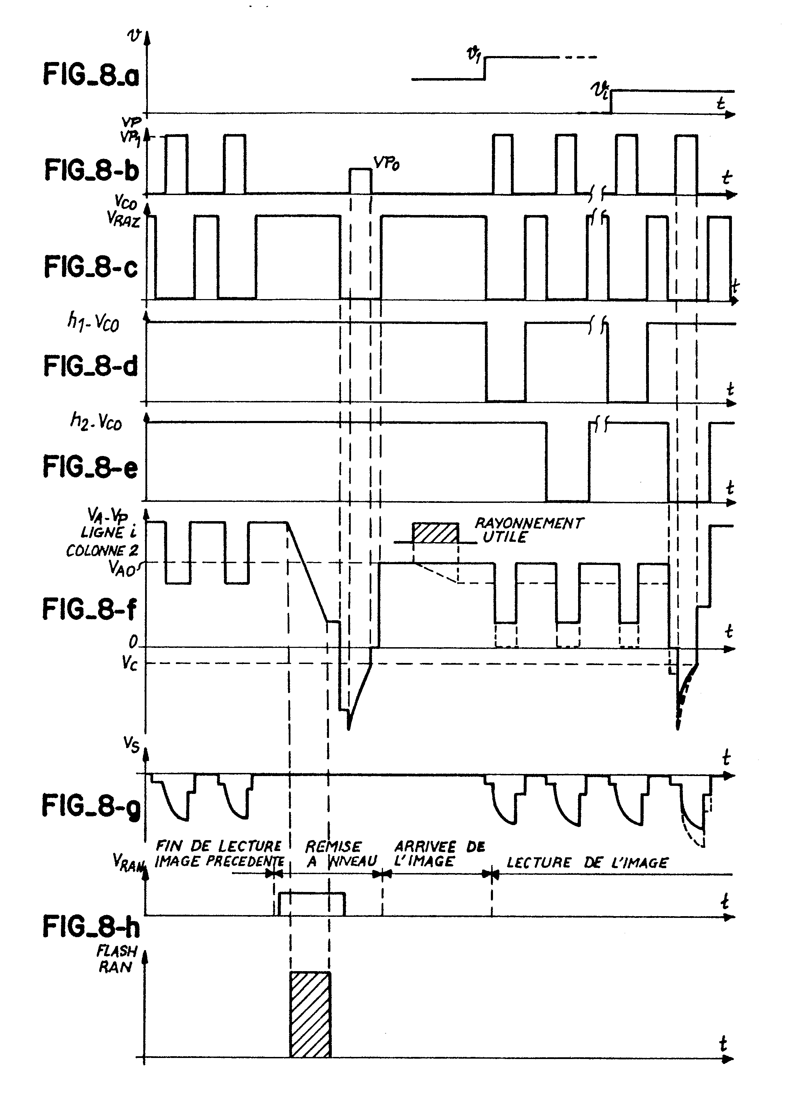

La remise à niveau peut également être obtenue au moyen d'un éclairement intense. Les signaux explicatifs de la variante du procédé de lecture mettant en oeuvre une telle remise à niveau sont représentés sur les figures 8a à 8h également dans le cas d'une application où la remise à niveau est effectuée pour tout le panneau en une seule fois. L'éclairement intense, non calibré, illustré par la figure 8h décharge la capacité C beaucoup plus qu'il ne serait nécessaire pour revenir à la tension de départ $V_{A0}$. Puis, une lecture à blanc est effectuée au moyen d'une impulsion de lecture supplémentaire représentée sur la figure 8b, de niveau calibré $V_{P0}$, inférieur à $V_{P1}$, semblable à celle introduite après une polarisation fortement inverse comme sur la figure 3b. Ainsi la tension au point A des diodes de la ligne à lire est ramenée à la tension de départ $V_{A0}$ nécessaire, sans que l'éclairement soit calibré. On introduit alors une charge de polarisation $Q_0 = C(V_{P1}-V_{P0})$. Du fait qu'une lecture à blanc est effectuée pour amener la tension à $V_{A0}$, l'intégration de l'information utile ne peut avoir lieu qu'après la séquence de remise à niveau de l'ensemble du panneau.

L'application de cette matrice à la prise de vue d'images radiologiques est une application dans laquelle il n'y a qu'une seule exposition et une seule lecture de la matrice. Dans ce cas, l'opération de remise à niveau est effectuée pour l'ensemble de la matrice, préalablement à une exposition comme indiqué ci-dessus. La lecture peut alors être effectuée ligne par ligne par un adressage électronique.

Pour d'autres applications, il est possible de prévoir une remise à niveau ligne par ligne par éclairement focalisé de la ligne à remettre à niveau, soit par un éclairement calibré, soit par un éclairement intense suivi pour cette ligne d'une lecture à blanc.

L'invention n'est pas limitée à la description précisément donnée ci-dessus, mais dans tous les cas, la remise à niveau nécessaire pour que l'opération de lecture soit effectuée correctement, quel que soit le niveau du signal analogique à lire par l'amplificateur opérationnel intégrateur, doit être adaptée à l'application envisagée.

## Revendications

1. Matrice d'éléments photosensibles comportant un ensemble de p lignes de n éléments photosensibles, chaque élément ayant une première et une seconde borne, caractérisée en ce que chaque élément comporte en série une photodiode (D) et une capacité (C), les premières bornes des éléments d'une même ligne étant interconnectées et reliées via un interrupteur (j) commandé par une sortie (v) d'un registre à décalage vertical (RV) à un potentiel d'adressage ligne (Vp), et les secondes bornes des éléments d'une même colonne étant interconnectées et reliées à un interrupteur (i), commandé par une sortie de l'un de $\underline{M}$ registres à décalage horizontaux à $\frac{n}{M}$ étages (RH$_1$,...RH$_M$), en série avec l'entrée "-" de l'un des M amplificateurs opérationnels (A$_1$,...A$_M$) montés en intégrateur, les entrées "+" des intégrateurs étant reliées à l'entrée d'adressage colonne (V$_{CO}$), chaque conducteur de colonne étant également relié, via un interrupteur (i") commandé par des impulsions de remise à niveau (V$_{RAN}$) à l'entrée d'adressage colonne (V$_{CO}$), les entrées de commande de décalage des registres horizontaux étant reliées à une même entrée de commande (C$_{DH}$), chaque intégrateur comportant des moyens de remise à zéro de la capacité (C$_L$) d'intégration.

2. Procédé de fabrication d'une matrice d'éléments photosensibles, caractérisé en ce qu'il consiste :
- à déposer sur un substrat transparent (1) une première couche de matériau conducteur semi-transparent (2) et à la graver pour obtenir des conducteurs parallèles,
- à déposer sur cet ensemble des couches successives (4, 5, 6) de matériau semi-conducteur, respectivement dopée, non dopée et dopée nécessaires pour former des diodes photosensibles, puis à les graver pour isoler des diodes,
- à recouvrir cet ensemble d'une couche de matériau diélectrique pour réaliser des capacités, en série avec les diodes,
- puis, à déposer une couche de matériau conducteur semi-transparent (7) sur la couche diélectrique, et à la graver pour réaliser des conducteurs de colonne orthogonaux aux conducteurs de ligne et reliant les capacités d'une même ligne.

3. Procédé de fabrication d'une matrice d'éléments photosensibles caractérisé en ce qu'il consiste :
- à déposer sur un substrat transparent (1) une première couche de matériau conducteur semi-transparent (2) et à la graver pour obtenir des conducteurs parallèles,
- à déposer une couche (3) de matériau à forte constante diélectrique pour réaliser des capacités de faible épaisseur,
- à déposer sur ce matériau diélectrique des couches successives (4, 5, 6) de matériau semi-conducteurs, respectivement dopée, non dopée et dopée nécessaires pour former des diodes photosensibles, puis à les graver pour isoler des diodes,
- à recouvrir cet ensemble d'une couche d'isolant (6) et à ouvrir cette couche d'isolant au niveau supérieur des diodes.
- à déposer sur l'ensemble une couche de matériau conducteur semi-transparent (7) et à la graver pour former les conducteurs de colonne orthogonaux aux conducteurs de ligne et reliant les diodes d'une même ligne.

4. Procédé selon l'une des revendications 2 et 3, caractérisé en ce que, pour obtenir une matrice utilisable en imagerie par rayon X, une couche de matériau scintillateur 9 est ensuite déposée sur l'ensemble.

5. Procédé de fabrication selon l'une des revendications 2, 3 et 4 caractérisé en ce que les couches de matériau semi-conducteurs sont des couches de silicium amorphe.

6. Procédé de lecture d'une matrice d'éléments photosensibles selon la revendication 1, caractérisé :
- en ce que pour la lecture, les registres à décalage horizontaux sont commandés en parallèle, la lecture des colonnes étant multiplexée : les éléments photosensibles d'une ligne sont adressés par une tension d'adressage appliquée simultanément aux colonnes de rangs $k$, $k + \frac{n}{M}$, $k + 2\frac{n}{M}$..., au moyen des sorties de rang k des registres à décalage horizontaux, k étant un nombre entier compris entre 1 et $\frac{n}{M}$, une séquence d'adressage de colonnes comportant une séquence de $\frac{n}{M}$ impulsions, - et en ce qu'une phase de remise à niveau des tensions aux bornes des diodes est prévue, par application d'un fond de charge (Q$_0$) aux éléments photosensibles, entre les séquences de lecture, pour ramener la tension aux bornes des diodes d'une ligne à lire à une valeur initiale V$_{A0}$telle que les impulsions de lecture ligne (V$_{P1}$) seules ne puissent les polariser en direct même après un éclairement maximum, et que les impulsions de commande ligne (V$_{P1}$) associées aux impulsions d'adressage colonne (V$_{CO}$) les polarise fortement en direct, même en l'absence de rayonnement utile.

7. Procédé de lecture selon la revendication 6, caractérisé en ce que la remise à niveau est effectuée après chaque séquence de lecture de ligne et obtenue :
- par application d'une impulsion de polarisation négative (V$_{P2}$) sur le conducteur de la ligne lue, pour décharger les capacités (C) des éléments photosensibles de la ligne, la tension aux bornes des diodes dépassant la tension de coude inverse (V$_{CI}$) de la diode,
- puis par lecture à blanc des éléments de la ligne en leur appliquant simultanément une impulsion de commande colonne (V$_{CO}$) et une impulsion de commande ligne (V$_P$) d'amplitude fixée (V$_{P2}$) pour que la tension aux bornes des diodes de la ligne à la fin de cette phase de remise à niveau soit ramenée à la valeur initiale (V$_{A0}$).

8. Procédé de lecture selon la revendication 6, adapté à la prise de vue d'images par une exposition à un signal utile et une lecture de l'ensemble de la matrice dans laquelle la lecture d'une image précédente amène les diodes à une tension de polarisation plus fortement inverse que la tension initiale (V$_{A0}$), caractérisé en ce que la phase de remise à niveau est réalisée en une seule fois pour toutes les diodes de la matrice par introduction d'un fond de charges calibré par éclairement uniforme de durée et d'intensité prédéterminées qui décale la tension aux bornes des diodes d'une quantité égale à la tension finale après la lecture précédente $(V_P-V_A)T_L$ diminuée de la tension initiale $(V_{AO})$.

9. Procédé selon la revendication 8, caractérisé en ce que la remise à niveau est effectuée à un instant quelconque entre la fin de la lecture d'une image et le début de la lecture de l'image suivante, et éventuellement en même temps que l'exposition au rayonnement utile.

10. Procédé de lecture selon la revendication 7, adapté à la prise de vue d'images par une exposition à un signal utile et une lecture de l'ensemble de la matrice dans laquelle la lecture d'une image précédente amène les diodes à une tension de polarisation plus fortement inverse que la tension initiale $(V_{AO})$, caractérisé en ce que la phase de remise à niveau est réalisée en une seule fois pour toutes les diodes de la matrice par introduction d'un fond de charges au moyen d'un éclairement intense non calibré, qui décale la tension aux bornes des diodes d'une valeur supérieur à la différence entre la tension finale à leurs bornes à la fin de la lecture de l'image précédente et la tension initiale $(V_{AO})$ nécessitée par la lecture, une phase de lecture à blanc de l'ensemble de la matrice par une impulsion de polarisation calibrée ramemant cette tension aux bornes des diodes à la valeur initiale $(V_{AO})$ nécessaire.

11. Application de la matrice d'éléments photosensibles selon la revendication 1, et du procédé de lecture associé, à la prise de vue d'images.

12. Application de la matrice d'éléments photosensibles selon la revendication 1, et du procédé de lecture associé, à la prise de vue d'images radiologiques.

0233104

FIG_1

FIG_2

0233104

FIG_3-a

FIG_3-b

FIG_3-c

FIG_3-d

FIG_3-e

FIG_3-f

FIG_3-g

FIG_3-h

FIG_4

0233104

## FIG_5-a

## FIG_5-b

## FIG_6-a

## FIG_6-b

FIG_7-a

FIG_7-b

FIN DE LECTURE | REMISE A NIVEAU | LECTURE DE L'IMAGE : | p SEQUENCES DE
IMAGE | | | h/M IMPULSIONS
PRECEDENTE | ET ARRIVEE DE | |
| L'IMAGE | $1^{ère}$ LIGNE ← $i^e$ LIGNE

FIG_7-c

FIG_7-d

LECTURE
$1^{ère}$ LIGNE
COL.1, $\frac{n}{M}+1$...

LECTURE
$i^e$ LIGNE
COL1, $\frac{n}{M}+1$

FIG_7-e

LECTURE
$1^{ère}$ LIGNE
COL.2, $\frac{n}{M}+2$

LECTURE
$i^e$ LIGNE
COL.2, $\frac{n}{M}+2$

FIG_7-f

RAYONNEMENT
UTILE

FIG_7-g

$V_{S1}$
($2^e$ COLONNE)

FIG_7-h

FLASH
RAN.

0233104

FIG_8.a

FIG_8-b

FIG_8-c

FIG_8-d

FIG_8-e

FIG_8-f

FIG_8-g

FIG_8-h

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-3 521 244  (P.K. WEIMER)<br>* Figures 5,7,8; colonne 4, ligne 44 - colonne 5, ligne 73 * | 1-3 | H 04 N    3/15<br>H 01 L   27/14 //<br>A 61 B    6/00 |
| | --- | | |
| A | US-A-4 400 409  (MASATSUGU IZU et al.)<br>* Figure 1; colonne 8, ligne 39 - colonne 9, ligne 68 * | 2,3,5 | |
| | --- | | |
| A,P | DE-A-3 531 448  (TOSHIBA)<br>* Figures 2-5;  page 11, lignes 1-7; page 11, lignes 16-18;  page 12, lignes 7-33 * | 1-5 | |
| | ----- | | |

**DOMAINES TECHNIQUES RECHERCHES (Int. Cl.4)**

H 04 N
H 01 L

Le présent rapport de recherche a été établi pour toutes les revendications

| Lieu de la recherche | Date d'achèvement de la recherche | Examinateur |
|---|---|---|
| LA HAYE | 28-04-1987 | MACHEK,J. |